# EUROPEAN PATENT APPLICATION

(11) **EP 4 749 929 A1**
(43) Date of publication of application: **27.05.2026**
(21) Application number: 25215253.3
(22) Date of filing: 12.11.2025
(51) Int. Cl.: H03L 7/089, H03L 7/099, H03L 7/18

(54) **VARIABLE-SPEED PHASE INTERPOLATOR**

(30) Priority: 25.11.2024 US 202463724879 P; 16.06.2025 US 202519239889
(71) Applicant: Samsung Electronics Co., Ltd., Suwon-si, Gyeonggi-do 16677 (KR)
(72) Inventor: PARK, Joung Won, San Jose, CA 95134 (US); KIM, Jaehyup, San Jose, CA 95134 (US); KANG, Dae Hyun, San Jose, CA 95134 (US)
(74) Representative: Kuhnen & Wacker Patent- und Rechtsanwaltsbüro PartG mbB

(57) **Abstract**

A variable-speed phase interpolator is provided. In some embodiments, a system includes: a phase-locked loop; a phase interpolator; and an interpolator control circuit. The phase-locked loop may include an oscillator and an oscillator control circuit. The oscillator control circuit may be configured to set a value of an oscillator parameter to control a frequency of oscillation of the oscillator. The interpolator control circuit may be configured to adjust a phase interpolator parameter of the phase interpolator based on the value of the oscillator parameter.

## Description

### FIELD

One or more aspects of embodiments according to the present disclosure relate to data links, and more particularly to a variable-speed phase interpolator.

### BACKGROUND

Data links may be used in various applications, such as between separately packaged devices, or between dies of a multi-chip module.

It is with respect to this general technical environment that aspects of the present disclosure are related.

The above information disclosed in this Background section is only for enhancement of understanding of the background and therefore the information discussed in this Background section does not necessarily constitute prior art.

### SUMMARY

According to an embodiment of the present disclosure, there is provided a system, including: a phase-locked loop; a phase interpolator; and an interpolator control circuit, the phase-locked loop including: an oscillator and an oscillator control circuit, the oscillator control circuit being configured to set a value of an oscillator parameter to control a frequency of oscillation of the oscillator, the interpolator control circuit being configured to adjust a phase interpolator parameter of the phase interpolator based on the value of the oscillator parameter.

In some embodiments, the oscillator parameter is a supply voltage of the oscillator.

In some embodiments, the phase interpolator parameter is a supply voltage of the phase interpolator.

In some embodiments, the interpolator control circuit includes a low dropout regulator.

In some embodiments, an output of the low dropout regulator is connected to a supply connection of the phase interpolator.

In some embodiments, the interpolator control circuit further includes an amplifier having an output connected to a control input of the low dropout regulator.

In some embodiments, a first input of the amplifier is connected to a supply connection of the oscillator, and a second input of the amplifier is connected to a supply connection of the phase interpolator.

According to an embodiment of the present disclosure, there is provided a method, including: setting, by an oscillator control circuit, a value of an oscillator parameter; and setting, by a clock-generating circuit, a phase interpolator parameter based on the value of the oscillator parameter, the clock-generating circuit including: a phase-locked loop; a phase interpolator; and an interpolator control circuit, the phase-locked loop including: an oscillator and the oscillator control circuit.

In some embodiments, the oscillator parameter is a supply voltage of the oscillator.

In some embodiments, the phase interpolator parameter is a supply voltage of the phase interpolator.

In some embodiments, the interpolator control circuit includes a low dropout regulator.

In some embodiments, an output of the low dropout regulator is connected to a supply connection of the phase interpolator.

In some embodiments, the interpolator control circuit further includes an amplifier having an output connected to a control input of the low dropout regulator.

In some embodiments, a first input of the amplifier is connected to a supply connection of the oscillator, and a second input of the amplifier is connected to a supply connection of the phase interpolator.

According to an embodiment of the present disclosure, there is provided a system, including: a voltage-controlled oscillator; an oscillator control circuit; a phase interpolator; and an interpolator control circuit, the voltage-controlled oscillator being configured to generate a plurality of clock phases, the phase interpolator being configured to generate an intermediate phase from two phases of the plurality of clock phases, the oscillator control circuit being configured to set a value of an oscillator parameter to control a frequency of oscillation of the voltage-controlled oscillator, the interpolator control circuit being configured to adjust a phase interpolator parameter based on the value of the oscillator parameter.

In some embodiments, the oscillator parameter is a supply voltage of the voltage-controlled oscillator.

In some embodiments, the phase interpolator parameter is a supply voltage of the phase interpolator.

In some embodiments, the interpolator control circuit includes a low dropout regulator.

In some embodiments, an output of the low dropout regulator is connected to a supply connection of the phase interpolator.

In some embodiments, the interpolator control circuit further includes an amplifier having an output connected to a control input of the low dropout regulator.

### BRIEF DESCRIPTION OF THE DRAWINGS

These and other features and advantages of the present disclosure will be appreciated and understood with reference to the specification, claims, and appended drawings wherein:
FIG. 1A is a block diagram of a system including a plurality of interconnected digital circuits, according to an embodiment of the present disclosure;
FIG. 1B is a block diagram of two interconnected digital circuits, according to an embodiment of the present disclosure;
FIG. 1C is a block diagram of a transmitter and a receiver, according to an embodiment of the present disclosure;
FIG. 2A is a schematic diagram of a summing circuit, according to an embodiment of the present disclosure;
FIG. 2B is a graph of rising edges, according to an embodiment of the present disclosure;
FIG. 2C is a graph of rising edges, according to an embodiment of the present disclosure;
FIG. 2D is a graph of rising edges, according to an embodiment of the present disclosure;
FIG. 3 is schematic diagram of a clock-generating circuit, according to an embodiment of the present disclosure;
FIG. 4A is a schematic drawing of a portion of a voltage-controlled oscillator, according to an embodiment of the present disclosure;
FIG. 4B is a schematic drawing of a portion of a phase interpolator, according to an embodiment of the present disclosure; and
FIG. 5 is a flow chart of a method, according to an embodiment of the present disclosure.

### DETAILED DESCRIPTION

The detailed description set forth below in connection with the appended drawings is intended as a description of aspects of some embodiments of a variable-speed phase interpolator provided in accordance with the present disclosure and is not intended to represent the only forms in which the present disclosure may be constructed or utilized. The description sets forth the features of the present disclosure in connection with the illustrated embodiments. It is to be understood, however, that the same or equivalent functions and structures may be accomplished by different embodiments that are also intended to be encompassed within the scope of the disclosure. As denoted elsewhere herein, like element numbers are intended to indicate like elements or features.

In various electronic and computer systems, it may be desirable to enable components in the system, such as graphics cards, hard drives (including, for example, solid state drives (SSDs)), memory devices, network components or adaptors, or other peripheral components or devices, to communicate with each other using high-speed data transmission links. Such high-speed data links may include, for example, Universal Chiplet Interconnect Express (UCle), Peripheral Component Interconnect Express (PCIe), Knights Landing Token Interface (KTI), Ultra Path Interconnect (UPI), QuickPath Interconnect (QPI), Universal Serial Bus (USB) and the like. Such data links may enable relatively high data transmission speeds, flexibility in bandwidth allocation, simultaneous data transmission, relatively low latency, among other characteristics.

In a data link, data may be transmitted from a transmitter component or circuit (hereinafter referred to as a "transmitter") to a receiver component or circuit (hereinafter referred to as a "receiver") along with a clock signal. The clock signal, which may include two complementary signals, may be produced by two phase interpolators in the transmitter. In some systems the bitstream may carry an embedded clock. In some embodiments, the clock is transmitted separately, as a forwarded clock.

Each one of the phase interpolators may combine (e.g., form a weighted sum of) the two clock phases, of, e.g., eight clock phases received from the clock, that are nearest the clock phase to be transmitted. The resulting interpolated clock signal (the signal formed as the weighted sum) may have a waveform that differs somewhat from the waveform of the clock phases received, by the phase interpolator, from the clock, but the waveform may be acceptable if, for example, the rise time and the fall time of rising and falling edges at the output of the summing circuit are approximately equal to one-eighth of the clock period.

For example, the transmitter may be designed to operate at a high clock frequency, e.g., 16 gigahertz (GHz) but it may also be connected, in some circumstances, to a receiver capable only of operating at a lower clock frequency, e.g., 4 GHz. As mentioned above, phase interpolator configured to perform phase interpolation at 16 GHz may do so by adding together two waveforms, in proportions corresponding to the interpolated phase to be provided, the two waveforms being clock signals separated by 45 degrees. The waveform resulting from the summing may, however, not be a good approximation to an intermediate-phase clock signal if the rise times of the rising edges (or the fall times of the falling edges) of the component clock signals are significantly shorter than one eighth of the clock frequency.

As such, in some embodiments, the strength, or speed, or delay, or rise time (each of which is a measure of, or a characteristic that affects, the transition speed at the output of the summing circuit) of the amplifiers of the summing circuit is adjusted during operation so that for various clock frequencies the rise time is approximately one eighth of the period of the clock. For example, it may be advantageous to slow the clock edges (e.g., to slow the amplifiers producing the clock edges) of the phase interpolator when the transmitter is being operated at low frequency. In some embodiments, this may be done in an automated fashion using the phase-locked loop of the transmitter, which follows the clock frequency as a result of feedback from the phase and frequency detector of the phase-locked loop to the voltage-controlled oscillator of the phase locked loop. During operation, the phase-locked loop may adjust the supply voltage of the voltage-controlled oscillator as the operating frequency changes. These supply voltage changes may result in strength, or speed changes in inverters (or "unit cells") of the voltage-controlled oscillator, causing the oscillator to oscillate at the changed clock frequency. In some embodiments, the same speed changes are caused in the unit cells (e.g., inverters) of the phase interpolator, by causing the supply voltage of the phase interpolator to be substantially equal to the supply voltage of the voltage-controlled oscillator. An interpolator control circuit, which may include an amplifier and a low-dropout regulator, may be used to cause the supply voltage of the phase interpolator to be substantially equal to the supply voltage of the voltage-controlled oscillator.

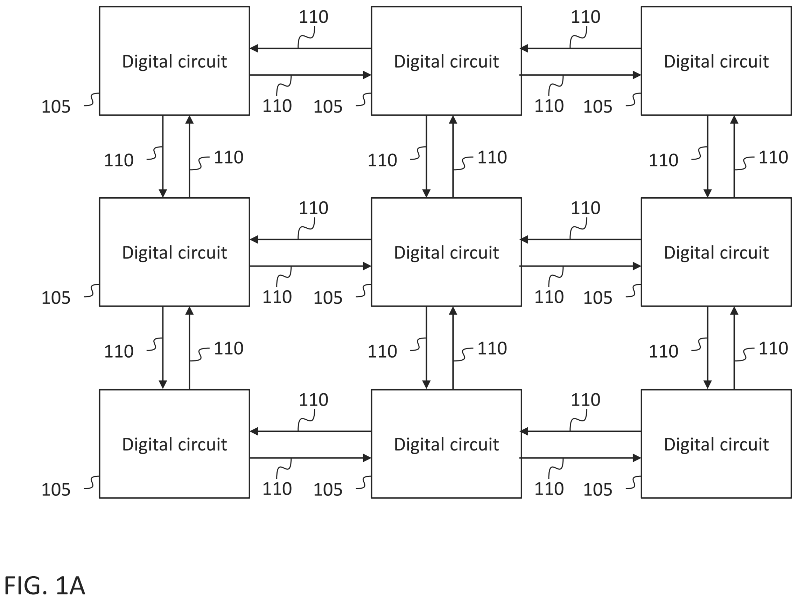

FIG. 1A shows a system-level diagram of a system including a plurality of digital circuits 105. Each of these circuits may be a single semiconductor chip (e.g., a silicon digital integrated circuit) such as a tensor flow processing unit (TPU), a central processing unit (CPU), a graphics processing unit (GPU), or a special purpose integrated circuit (e.g., a silicon application-specific integrated circuit (ASIC)), a hard drive (e.g., a solid state drive (SSD)), a memory device, a network component or adaptor, or other peripheral component or device. The digital circuits 105 may be connected by a plurality of data links 110, each of which may be a data link utilizing a data link protocol or mechanism. Such data links may make it possible, for example, for the digital circuits 105 to send data (e.g., data to be processed, or data that has been processed by one or more of the digital circuits 105) to each other. For example, a first digital circuit 105 may process data it receives (e.g., from off-chip or on-chip memory) and send the result to a second digital circuit 105. Communications between the plurality of digital circuits 105 and other circuits (e.g., memory circuits for storing data to be processed) may be performed over additional data links (not shown).

In some embodiments, each of the data links 110 is a Universal Chiplet Interconnect Express (UCle) data link, although embodiments according to the present disclosure are not limited thereto, and according to various embodiments, the data links 110 may utilize other data link protocols or mechanisms. A Universal Chiplet Interconnect Express (UCle) data link may be a data link that complies with an open industry standard (the UCle standard) designed to facilitate die-to-die interconnects and communication between dies (or "chiplets") in a multi-chip module (e.g., in a multi-chip system on a chip (SoC)). UCle may be used as a universal interconnect at the package level (e.g., within the package of a multi-chip module (e.g., a multi-chip SoC)).

The UCle standard specifies a standardized die-to-die interconnect that includes the physical layer, protocol stack, software model, and compliance testing procedures. The standardization allows components produced by different manufacturers to be inter-compatible. The physical layer of UCle supports relatively fast data transfer rates (e.g., up to 32 giga bits per second (Gbps)) over multiple lanes (e.g., between 16 and 64 lanes). Like a peripheral component interconnect express (PCle) 6.0 link, a UCle link may use a 256-byte Flow Control Unit (FLIT) for data transmission. The physical specifications of the UCle standard are based on the Advanced Interface Bus (AIB) specifications; these physical specifications may result in high performance and power efficiency.

The UCle protocol layer is based on the Compute Express Link (CXL) standard and includes the CXL.io (PCle), CXL.mem, and CXL.cache protocols. A data link complying with UCle may be compatible with various interconnect technologies, including organic substrates for standard 2D packages and embedded silicon bridges (e.g., embedded multi-die interconnect bridges EMIBs), silicon interposers, and fanout embedded bridges. Such interconnect technologies may enhance bandwidth density and power efficiency. A data link complying with UCle may exhibit significantly higher I/O performance and lower power consumption than, for example, a PCle serializer de-serializer (SerDes). For example, a data link complying with UCle may provide bandwidth density up to 1.35 TB/s per mm² for a bump pitch of 45 µm.

Data links complying with UCle may be used in various applications, including high-performance computing data centers, edge computing, and automotive and high-reliability applications. Data links complying with UCle may be suitable for high-performance computing applications, in which efficient interconnects between dies may be important. In a data center, the use of data links complying with UCle may make possible the integration of diverse dies, allowing for customized solutions.

Artificial intelligence and machine learning applications may be benefit from the high bandwidth and low latency that data links complying with UCle may exhibit. By enabling efficient data transfer between dies, data links complying with UCle may make possible the rapid processing and analysis of large datasets. In edge computing, data links complying with UCle may provide a portion of the infrastructure for deploying and managing dies at the edge of a network.

In automotive and high-reliability applications, data links complying with UCle may provide runtime health monitoring and repair features (which are part of the UCle specification). These features may ensure the robustness and reliability of the data links, allowing them to be suitable for safety-critical systems. Data links complying with UCle are compatible with three-dimensional (3D) packaging, with which high packaging densities may be achieved.

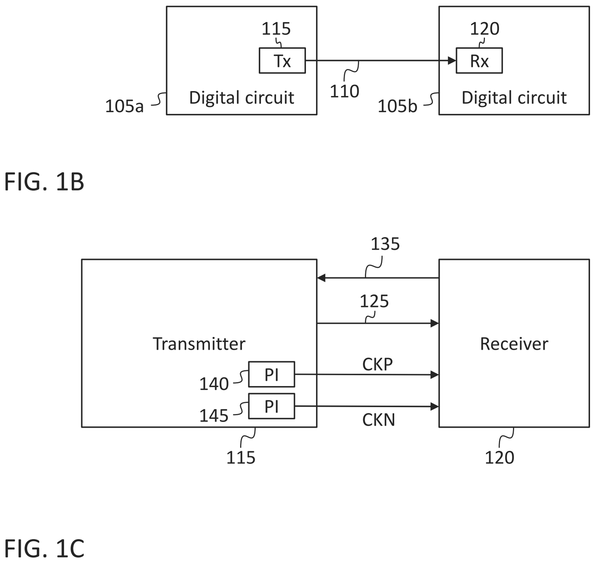

FIG. 1B shows a data link 110 between a first digital circuit 105a and a second digital circuit 105b, from among the digital circuits 105. The first digital circuit 105a includes a transmitter (Tx) (e.g., a UCle transmitter) 115 and the second digital circuit 105b includes a receiver (Rx) (e.g., a UCle receiver) 120. Although FIG. 1B illustrates the first digital circuit 105a including a transmitter 115 and the second digital circuit 105b including a receiver 120 for convenience of illustration and description, in various embodiments, each of the digital circuits may include both a transmitter and a receiver or a transceiver. The transmitter 115 may operate, for example, to convert or encode digital data from the first digital circuit 105a into a bitstream and transmit the bitstream over the physical medium (e.g., conductive wiring, optical fiber, and the like) of the data link 110 to the receiver 120 of the second digital circuit 105b.

FIG. 1C shows connections between the transmitter 115 and the receiver 120. The data link 110 may include a data channel 125 and a clock channel, each of which may include a pair of conductors forming a transmission line for transmitting complementary (e.g., differential) signals. The widths of the conductors, and the separation between the conductors of each pair of conductors may be selected to provide a characteristic impedance specified by the UCle standard, and both (i) the data and clock outputs of the transmitter 115 and (ii) the data and clock inputs of the receiver 120 may be impedance-matched to the characteristic impedance of the transmission line. As shown in FIG. 1C, the two differential signals of the clock signal (CKP and CKN) may be generated by a first phase interpolator (PI) 140 and a second phase interpolator 145. The phase of each phase interpolator 140, 145, may be controlled by a respective digital control signal (e.g., a 5-bit control signal), which may be referred to as a phase interpolator control signal.

A sideband channel 135 may be used to send feedback or control signals from the receiver 120 to the transmitter 115. In operation (e.g., at startup), the transmitter 115 may sweep the phase of the clock over a range of clock phases while sending data (e.g., a set pseudorandom bit pattern) to the receiver 120, and the receiver 120 may send, to the transmitter 115, indications of whether the data is being successfully received. The transmitter 115 may then determine the range of phase values over which the data is successfully received, and, for subsequent operation, set the operating phase to the midpoint of this range.

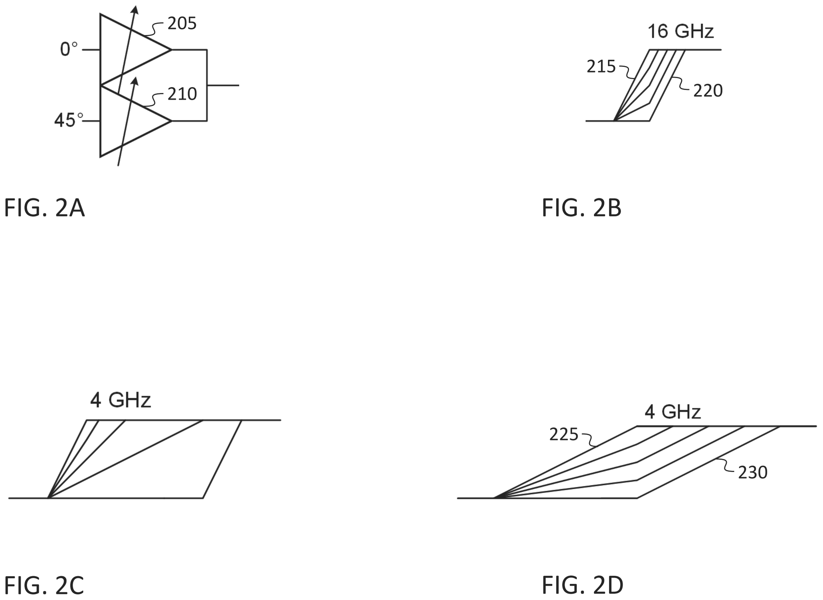

The first phase interpolator 140 may receive eight clock phases spaced 45 degrees apart, and, to generate an arbitrary phase it may add together the two clock phases that are nearest the desired phase, as shown by the summing circuit of FIG. 2A, in proportions selected to approximate a desired intermediate phase. For example, FIG. 2A shows a first amplifier 205 amplifying a clock signal at zero degrees, and a second amplifier 210 amplifying a clock signal delayed by 45 degrees. Each of the first amplifier 205 and the second amplifier 210 may have variable strength, or variable capacity to source or sink current, which may be adjusted, for example, by adjusting the supply voltage, or by adjusting in each amplifier the number of transistors of a bank of output stage transistors that is enabled and contributes to the output current. For brevity some of the examples discussed herein are directed to the first phase interpolator 140 only; the second phase interpolator 145 may be operated in an analogous manner.

FIG. 2B shows a rising edge of each of five 16 GHz clock waveforms that may be produced by the circuit of FIG. 2A, including a first waveform 215 produced when the strength of the first amplifier 205 is set to maximum and the second amplifier 210 is shut off, and a fifth waveform 220 produced when the strength of the second amplifier 210 is set to maximum and the first amplifier 205 is shut off, and three intermediate waveforms for each of which both the first amplifier 205 and the second amplifier 210 are turned on with different relative strengths, to achieve intermediate phases. It may be seen that although the shapes of the rising edges of the intermediate waveforms are not identical to those of the first waveform 215 and the fifth waveform 220, the intermediate waveforms are good approximations of clock signals with phases that are between those of the first waveform 215 and the fifth waveform 220.

FIG. 2C shows a set of waveforms that may be expected if the circuit of FIG. 2A is used with a clock frequency of 4 GHz. Because the first amplifier 205 and the second amplifier 210 are capable of switching with a rise time suitable for a 16 GHz clock signal (e.g., capable of producing a rise time of approximately one-eighth of a cycle of a 16 GHz clock signal) the waveforms of the intermediate phases are poor approximations to clock signals with phases that are between a clock phase of zero degrees and a clock phase of 45 degrees.

FIG. 2D shows a rising edge of each of five 4 GHz clock waveforms that may be produced by the circuit of FIG. 2A, or a modified version of the circuit of FIG. 2A. The waveforms include a first waveform 225 produced when the strength of the first amplifier 205 is set to maximum and the second amplifier 210 is shut off, and a fifth waveform 230 produced when the strength of the second amplifier 210 is set to maximum and the first amplifier 205 is shut off, and three intermediate waveforms for each of which both the first amplifier 205 and the second amplifier 210 are turned on with different relative strengths, to achieve intermediate phases. To generate the waveforms of FIG. 2D, both the first amplifier 205 and the second amplifier 210 may be modified (e.g., by the use of smaller (narrower channel) transistors) to have lower (e.g., a factor of 4 lower) maximum strength than those of the first amplifier 205 and the second amplifier 210 of FIG. 2A, or the strength of both amplifiers may be reduced by other means, e.g., by reducing the supply voltage or by reducing in each of the first amplifier 205 and the second amplifier 210 the number of transistors of a bank of output stage transistors that is enabled and contributes to the output current. It may be seen in FIG. 2D that although the shapes of the rising edges of the intermediate waveforms are not identical to those of the first waveform 225 and the fifth waveform 230, the intermediate waveforms are good approximations of clock signals with phases that are between those of the first waveform 225 and the fifth waveform 230.

As such, in a transmitter that is expected or required to operate over a range of clock frequencies, it may be advantageous to adjust not only the relative strength of the two drive amplifiers in each of the phase interpolators 140, 145 to produce intermediate phases, but also to adjust the total drive strength of the amplifiers in accordance with the clock frequency, e.g., to decrease the drive strength of both amplifiers for lower clock frequencies and the increase the drive strength of both amplifiers for higher clock frequencies.

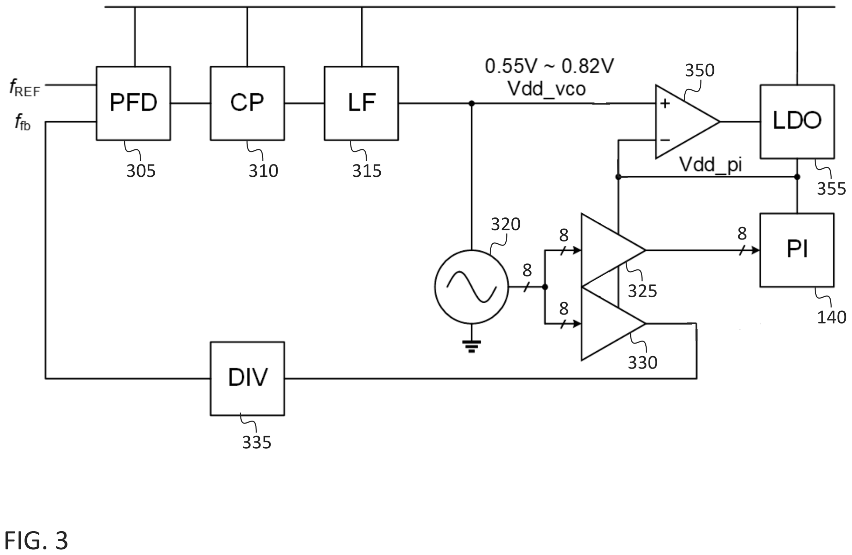

FIG. 3 shows a clock-generating circuit of a transmitter 115, in some embodiments. This circuit includes a phase-locked loop in which a phase and frequency detector 305 (PFD) receives an external frequency reference signal f_{REF} and a feedback signal f_{fb}, and produces an error signal (or a frequency error signal and a phase error signal) that is sent to a charge pump (CP) 310. The output of the charge pump 310 is connected to the input of a loop filter (LF) 315 which controls the supply voltage of a voltage-controlled oscillator (VCO) 320. The combination of the phase and frequency detector 305, the charge pump 310, and the loop filter 315 may be referred to as an oscillator control circuit. The output of the voltage-controlled oscillator 320, which includes eight clock phases, drives a first clock amplifier 325 and a second clock amplifier 330. The second clock amplifier 330 drives a frequency divider (DIV) 335, the output of which is the feedback signal, which is fed to the phase and frequency detector 305. The first clock amplifier 325 drives the first phase interpolator 140.

In some embodiments, the delay of the first phase interpolator 140 is adjusted automatically as the clock frequency changes, as follows. The delay of each stage of the voltage-controlled oscillator 320, which may be a ring oscillator, may be controlled in part by the supply voltage, which in turn is controlled by the charge pump 310. For example, the delay of each stage of the ring oscillator of the voltage-controlled oscillator 320 may decrease if the supply voltage is increased. The delay of the amplifiers of the first phase interpolator 140 may similarly depend on the supply voltage supplied to the first phase interpolator 140. In some embodiments, the unit cells (e.g., inverters) of the first phase interpolator 140 are the same (e.g., they have the same size and P/N ratio as the unit cells of the voltage-controlled oscillator 320 (the P/N ratio being the ratio of the channel width of the p-channel metal oxide semiconductor (PMOS) transistors to the channel width of the n-channel metal oxide semiconductor (NMOS) transistors)). The use of a shared supply voltage may also make it possible to avoid the use of AC-coupled amplifiers, and some or all of the amplifiers of the circuit of FIG. 3 may be DC-coupled.

The adjustment of the supply voltage of the voltage-controlled oscillator 320 is performed automatically, by the feedback loop; as such, providing the same supply voltage to the first phase interpolator 140 may cause the delay of the first phase interpolator 140 to be adjusted automatically as the clock frequency varies. In some embodiments, the controlling of the supply voltage of the first phase interpolator 140 is accomplished by an interpolator control circuit which may include a voltage amplifier 350 and a low-dropout regulator (LDO) 355, as illustrated in FIG. 3. As shown in FIG. 3, the output of the low dropout regulator 355 is connected to a supply connection of the first phase interpolator 140, the voltage amplifier 350 has an output connected to a control input of the low dropout regulator 355, and a first input of the voltage amplifier 350 is connected to a supply connection of the voltage-controlled oscillator 320, and a second input of the voltage amplifier 350 is connected to a supply connection of the first phase interpolator 140.

The voltage amplifier 350 and a low-dropout regulator 355 form a voltage-control loop that keeps the supply voltage of the first phase interpolator 140 equal to the supply voltage of the voltage-controlled oscillator 320, while providing a high-impedance connection to the output of the loop filter 315. This may be advantageous because the output impedance of the loop filter 315 may be sufficiently high that a direct connection from the output of the loop filter 315 to the power supply input of the first phase interpolator 140 may load the output of the loop filter 315 enough to affect (e.g., degrade) the control of the voltage-controlled oscillator 320. The low-dropout regulator 355 may include an internal loop filter to ensure that a stable voltage is maintained at the supply connection (e.g., the power supply connection) of the first phase interpolator 140. In some embodiments, the loop shaping is also, or instead, implemented in, or in a feedback network around, the voltage amplifier 350; in such an embodiment a different current or voltage regulating element (e.g., a single, suitably sized transistor) may be substituted for the low-dropout regulator 355.

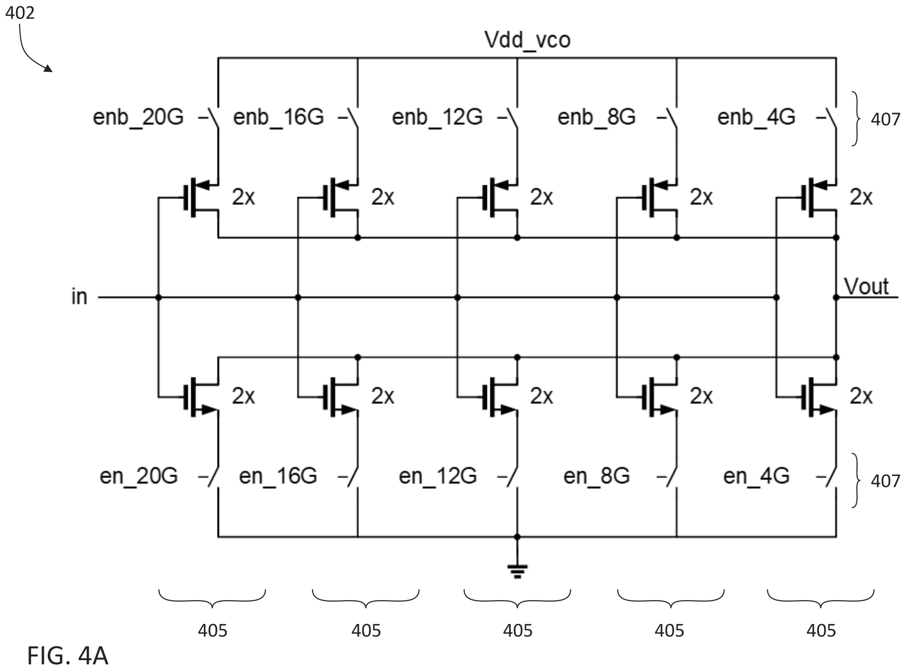

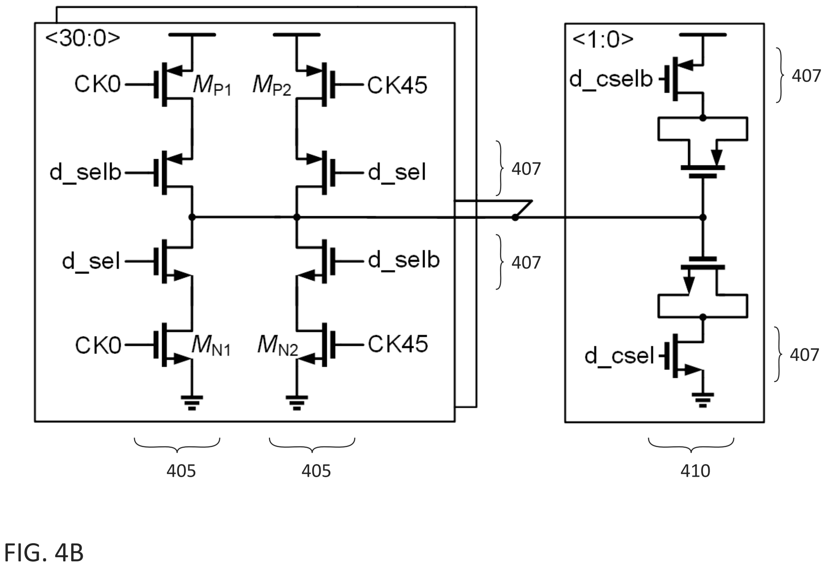

FIGs. 4A and 4B show transistor-level circuit diagrams of (i) a portion of the ring oscillator of the voltage-controlled oscillator 320 and (ii) the first amplifier 205 and the second amplifier 210 of the first phase interpolator 140, respectively. Referring to FIG. 4A, the ring oscillator of the voltage-controlled oscillator 320 may include a plurality of inverter stages 402 each of which may include a plurality of inverters 405 connected in parallel. The inverter stages 402 (of which there may be an odd number, e.g., three) may be connected in cascade in a ring. The speed of each stage may be adjusted by (i) enabling or disabling the inverters, using the enabling switches 407 or (ii) (as mentioned above) adjusting the supply voltage Vdd_vco. In some embodiments, the switches 407 may be controlled by sideband instructions, or by an instruction received from a module controller, which may be a processing circuit managing the operation of the multi-chip module within which the data link may be implemented.

In some embodiments, the switches may be used to desaturate the control loop that controls the supply voltage; for example, if the supply voltage approaches the maximum available supply voltage, the circuit may close one or more of the enabling switches 407 to increase the speed of the inverter stages 402, allowing the supply voltage to be reduced.

Referring to FIG. 4B, each of the first amplifier 205 and the second amplifier 210 may be constructed as the parallel combination of a plurality of inverters (e.g., 31 inverters), with the first amplifier 205 amplifying the 0 degree clock signal (CK0) and the second amplifier 210 amplifying the 45 degree clock signal (CK45). Each inverter may be enabled by a respective pair of enabling switches 407 as shown. The output of the parallel combination of inverters may be loaded by one or more pairs of programmable capacitors 410 (e.g., metal oxide semiconductor capacitors (MOS capacitors)) connected in series with enabling switches 407 as shown, to further adjust the speed of the first amplifier 205 and the second amplifier 210. For example, for high frequency (e.g., 16 GHz) operation, two sets of the <30:0> devices may be turned on and all programmable capacitors may be turned off. For low frequency (e.g., 4 GHz) operation, only one set of the <30:0> devices may be turned on, and all of the programmable capacitors may be turned on.

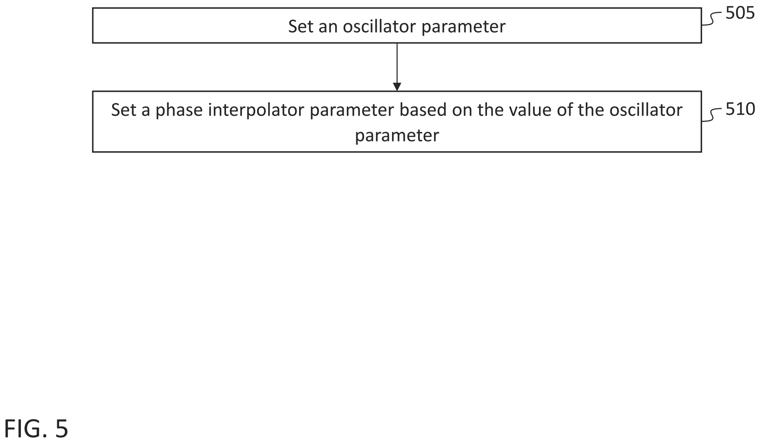

FIG. 5 shows a method of controlling the speed of a phase interpolator, in some embodiments. Although FIG. 5 illustrates various operations in such a method, embodiments according to the present disclosure are not limited thereto. For example, according to some embodiments, such a method may include additional operations or fewer operations, or the order of operations may vary (unless otherwise explicitly stated or implied) without departing from the scope of embodiments according to the present disclosure. The method includes setting, at 505, by an oscillator control circuit, an oscillator parameter. For example, as discussed above in the context of FIG. 3, the oscillator control circuit may cause the supply voltage of the voltage-controlled oscillator 320 to change, in response to a phase or frequency error detected by the phase and frequency detector 305. The method further includes setting, at 510, by a clock-generating circuit, a phase interpolator parameter based on the value of an oscillator parameter. For example, as discussed above, in the context of FIG. 3, the interpolator control circuit may provide the same supply voltage to the first phase interpolator 140 as is provided to the voltage-controlled oscillator 320, so that, as the clock frequency varies, the strength (e.g., the speed) of each inverter in the first phase interpolator 140 varies in the same way as the strength of each inverter of the voltage-controlled oscillator 320.

As used herein, "a portion of" something means "at least some of" the thing, and as such may mean less than all of, or all of, the thing. As such, "a portion of" a thing includes the entire thing as a special case, i.e., the entire thing is an example of a portion of the thing. As used herein, when a second quantity is "within Y" of a first quantity X, it means that the second quantity is at least X-Y and the second quantity is at most X+Y. As used herein, when a second number is "within Y%" of a first number, it means that the second number is at least (1-Y/100) times the first number and the second number is at most (1+Y/100) times the first number. As used herein, the term "or" should be interpreted as "and/or", such that, for example, "A or B" means any one of "A" or "B" or "A and B".

The background provided in the Background section of the present disclosure section is included only to set context, and the content of this section is not admitted to be prior art. Any of the components or any combination of the components described (e.g., in any system diagrams included herein) may be used to perform one or more of the operations of any flow chart included herein. Further, (i) the operations are example operations, and may involve various additional steps not explicitly covered, and (ii) the temporal order of the operations may be varied.

Each of the terms "processing circuit" and "means for processing" is used herein to mean any combination of hardware, firmware, and software, employed to process data or digital signals. Processing circuit hardware may include, for example, application specific integrated circuits (ASICs), general purpose or special purpose central processing units (CPUs), digital signal processors (DSPs), graphics processing units (GPUs), and programmable logic devices such as field programmable gate arrays (FPGAs). In a processing circuit, as used herein, each function is performed either by hardware configured, i.e., hardwired, to perform that function, or by more general-purpose hardware, such as a CPU, configured to execute instructions stored in a non-transitory storage medium. A processing circuit may be fabricated on a single printed circuit board (PCB) or distributed over several interconnected PCBs. A processing circuit may contain other processing circuits; for example, a processing circuit may include two processing circuits, an FPGA and a CPU, interconnected on a PCB.

As used herein, the term "array" refers to an ordered set of numbers regardless of how stored (e.g., whether stored in consecutive memory locations, or in a linked list).

As used herein, when a method (e.g., an adjustment) or a first quantity (e.g., a first variable) is referred to as being "based on" a second quantity (e.g., a second variable) it means that the second quantity is an input to the method or influences the first quantity, e.g., the second quantity may be an input (e.g., the only input, or one of several inputs) to a function that calculates the first quantity, or the first quantity may be equal to the second quantity, or the first quantity may be the same as (e.g., stored at the same location or locations in memory as) the second quantity.

It will be understood that, although the terms "first", "second", "third", etc., may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed herein could be termed as a second element, component, region, layer or section, without departing from the scope of the inventive concept.

The terminology used herein is for the purpose of describing particular embodiments only and is not intended to be limiting of the inventive concept. As used herein, the terms "substantially," "about," and similar terms are used as terms of approximation and not as terms of degree, and are intended to account for the inherent deviations in measured or calculated values that would be recognized by those of ordinary skill in the art.

As used herein, the term "and/or" includes any and all combinations of one or more of the associated listed items. Expressions such as "at least one of," when preceding a list of elements, modify the entire list of elements and do not modify the individual elements of the list. Further, the use of "may" when describing embodiments of the inventive concept refers to "one or more embodiments of the present disclosure". Also, the term "exemplary" is intended to refer to an example or illustration. As used herein, the terms "use," "using," and "used" may be considered synonymous with the terms "utilize," "utilizing," and "utilized," respectively.

Any numerical range recited herein is intended to include all sub-ranges of the same numerical precision subsumed within the recited range. For example, a range of "1.0 to 10.0" or "between 1.0 and 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Similarly, a range described as "within 35% of 10" is intended to include all subranges between (and including) the recited minimum value of 6.5 (i.e., (1 - 35/100) times 10) and the recited maximum value of 13.5 (i.e., (1 + 35/100) times 10), that is, having a minimum value equal to or greater than 6.5 and a maximum value equal to or less than 13.5, such as, for example, 7.4 to 10.6. Any maximum numerical limitation recited herein is intended to include all lower numerical limitations subsumed therein and any minimum numerical limitation recited in this specification is intended to include all higher numerical limitations subsumed therein.

It will be understood that when an element is referred to as being "directly connected" or "directly coupled" to another element, there are no intervening elements present. As used herein, "generally connected" means connected by an electrical path that may contain arbitrary intervening elements, including intervening elements the presence of which qualitatively changes the behavior of the circuit. As used herein, "connected" means (i) "directly connected" or (ii) connected with intervening elements, the intervening elements being ones (e.g., low-value resistors or inductors, or short sections of transmission line) that do not qualitatively affect the behavior of the circuit.

Some embodiments may include features of the following numbered statements.
1. A system, comprising:
   a phase-locked loop;
   a phase interpolator; and
   an interpolator control circuit,
   the phase-locked loop comprising:
      an oscillator; and
      an oscillator control circuit,
   the oscillator control circuit being configured to set a value of an oscillator parameter to control a frequency of oscillation of the oscillator,
   the interpolator control circuit being configured to adjust a phase interpolator parameter of the phase interpolator based on the value of the oscillator parameter.
2. The system of statement 1, wherein the oscillator parameter is a supply voltage of the oscillator.
3. The system of statement 2, wherein the phase interpolator parameter is a supply voltage of the phase interpolator.
4. The system of statement 3, wherein the interpolator control circuit comprises a low dropout regulator.
5. The system of statement 4, wherein an output of the low dropout regulator is connected to a supply connection of the phase interpolator.
6. The system of statement 4 or statement 5, wherein the interpolator control circuit further comprises an amplifier having an output connected to a control input of the low dropout regulator.
7. The system of statement 6, wherein a first input of the amplifier is connected to a supply connection of the oscillator, and a second input of the amplifier is connected to a supply connection of the phase interpolator.
8. A method, comprising:
   setting, by an oscillator control circuit, a value of an oscillator parameter; and
   setting, by a clock-generating circuit, a phase interpolator parameter based on the value of the oscillator parameter,
   the clock-generating circuit comprising:
      a phase-locked loop;
      a phase interpolator; and
      an interpolator control circuit,
   the phase-locked loop comprising:
      an oscillator and
      the oscillator control circuit.
9. The method of statement 8, wherein the oscillator parameter is a supply voltage of the oscillator.
10. The method of statement 9, wherein the phase interpolator parameter is a supply voltage of the phase interpolator.
11. The method of statement 10, wherein the interpolator control circuit comprises a low dropout regulator.
12. The method of statement 11, wherein an output of the low dropout regulator is connected to a supply connection of the phase interpolator.
13. The method of statement 11 or statement 12, wherein the interpolator control circuit further comprises an amplifier having an output connected to a control input of the low dropout regulator.
14. The method of statement 13, wherein a first input of the amplifier is connected to a supply connection of the oscillator, and a second input of the amplifier is connected to a supply connection of the phase interpolator.
15. A system, comprising:
   a voltage-controlled oscillator;
   an oscillator control circuit;
   a phase interpolator; and
   an interpolator control circuit,
   the voltage-controlled oscillator being configured to generate a plurality of clock phases,
   the phase interpolator being configured to generate an intermediate phase from two phases of the plurality of clock phases,
   the oscillator control circuit being configured to set a value of an oscillator parameter to control a frequency of oscillation of the voltage-controlled oscillator,
   the interpolator control circuit being configured to adjust a phase interpolator parameter based on the value of the oscillator parameter.
16. The system of statement 15, wherein the oscillator parameter is a supply voltage of the voltage-controlled oscillator.
17. The system of statement 16, wherein the phase interpolator parameter is a supply voltage of the phase interpolator.
18. The system of statement 17, wherein the interpolator control circuit comprises a low dropout regulator.
19. The system of statement 18, wherein an output of the low dropout regulator is connected to a supply connection of the phase interpolator.
20. The system of statement 18 or statement 19, wherein the interpolator control circuit further comprises an amplifier having an output connected to a control input of the low dropout regulator.

Although exemplary embodiments of a variable-speed phase interpolator have been specifically described and illustrated herein, many modifications and variations will be apparent to those skilled in the art. Accordingly, it is to be understood that a variable-speed phase interpolator constructed according to principles of this disclosure may be embodied other than as specifically described herein. The invention is also defined in the following claims.

## Claims

1. A system, comprising:
a phase-locked loop;
a phase interpolator; and
an interpolator control circuit,
the phase-locked loop comprising:
an oscillator; and
an oscillator control circuit,
the oscillator control circuit being configured to set a value of an oscillator parameter to control a frequency of oscillation of the oscillator,
the interpolator control circuit being configured to adjust a phase interpolator parameter of the phase interpolator based on the value of the oscillator parameter.

2. The system of claim 1, wherein the oscillator parameter is a supply voltage of the oscillator.

3. The system of claim 2, wherein the phase interpolator parameter is a supply voltage of the phase interpolator.

4. The system of claim 3, wherein the interpolator control circuit comprises a low dropout regulator.

5. The system of claim 4, wherein an output of the low dropout regulator is connected to a supply connection of the phase interpolator.

6. The system of claim 4 or 5, wherein the interpolator control circuit further comprises an amplifier having an output connected to a control input of the low dropout regulator.

7. The system of claim 6, wherein a first input of the amplifier is connected to a supply connection of the oscillator, and a second input of the amplifier is connected to a supply connection of the phase interpolator.

8. The system of any one of the preceding claims, wherein:
the oscillator is a voltage-controlled oscillator;
the voltage-controlled oscillator is configured to generate a plurality of clock phases,
the phase interpolator is configured to generate an intermediate phase from two phases of the plurality of clock phases.

9. A method, comprising:
setting, by an oscillator control circuit, a value of an oscillator parameter; and
setting, by a clock-generating circuit, a phase interpolator parameter based on the value of the oscillator parameter,
the clock-generating circuit comprising:
a phase-locked loop;
a phase interpolator; and
an interpolator control circuit,
the phase-locked loop comprising:
an oscillator; and
the oscillator control circuit.

10. The method of claim 9, wherein the oscillator parameter is a supply voltage of the oscillator.

11. The method of claim 10, wherein the phase interpolator parameter is a supply voltage of the phase interpolator.

12. The method of claim 11, wherein the interpolator control circuit comprises a low dropout regulator.

13. The method of claim 12, wherein an output of the low dropout regulator is connected to a supply connection of the phase interpolator.

14. The method of claim 12 or 13, wherein the interpolator control circuit further comprises an amplifier having an output connected to a control input of the low dropout regulator.

15. The method of claim 14, wherein a first input of the amplifier is connected to a supply connection of the oscillator, and a second input of the amplifier is connected to a supply connection of the phase interpolator.
